# EUROPÄISCHE PATENTSCHRIFT

(11) **EP 1 198 844 B1**
(45) Veröffentlichungstag und Bekanntmachung des Hinweises auf die Patenterteilung: **07.03.2007**
(21) Anmeldenummer: 00951204.7
(22) Anmeldetag: 03.06.2000
(51) Int. Cl.: H01L 29/872, H01L 21/329

(54) **DIODE MIT METALL-HALBLEITERKONTAKT UND VERFAHREN ZU IHRER HERSTELLUNG**
DIODE COMPRISING A METAL SEMICONDUCTOR CONTACT AND A METHOD FOR THE PRODUCTION THEREOF
DIODE A CONTACT METAL-SEMI-CONDUCTEUR ET SON PROCEDE DE PRODUCTION

(30) Priorität: 03.07.1999 DE 19930781
(43) Veröffentlichungstag der Anmeldung: 24.04.2002
(73) Patentinhaber: ROBERT BOSCH GMBH, 70442 Stuttgart (DE)
(72) Erfinder: GOERLACH, Alfred, 72127 Kusterdingen (DE)
(86) Internationale Anmeldenummer: PCT/DE2000/001812
(87) Internationale Veröffentlichungsnummer: WO 2001/003204

(56) Entgegenhaltungen:
- EP-A- 0 275 179
- WO-A-99/12188
- DE-A- 2 733 840
- US-A- 5 217 911
- PATENT ABSTRACTS OF JAPAN vol. 009, no. 230 (E-343), 17. September 1985 (1985-09-17) & JP 60 084878 A (HITACHI SEISAKUSHO KK), 14. Mai 1985 (1985-05-14)

## Beschreibung

### Stand der Technik

Die Erfindung betrifft eine Diode mit einem zwischen zwei metallischen Elektroden angeordneten Halbleitersubstrat, das in einer ersten Zone stark dotiert ist, um einen ohmschen Übergang zu der ersten Elektrode zu bilden, und in einer zweiten Zone mit gleichem Leitfähigkeitstyp schwach dotiert ist, um einen gleichrichtenden Übergang zu der zweiten Elektrode zu bilden. Derartige Halbleiterdioden, auch als Schottky-Dioden bezeichnet, sind seit langem bekannt. Sie zeichnen sich durch einen geringen Spannungsabfall in Durchlaßrichtung und eine kurze Ausschaltzeit aus, da im Gegensatz zu pn- oder pin-Dioden keine Minoritätsladungsträger abgebaut werden müssen, um einen Stromfluß zum Erliegen zu bringen.

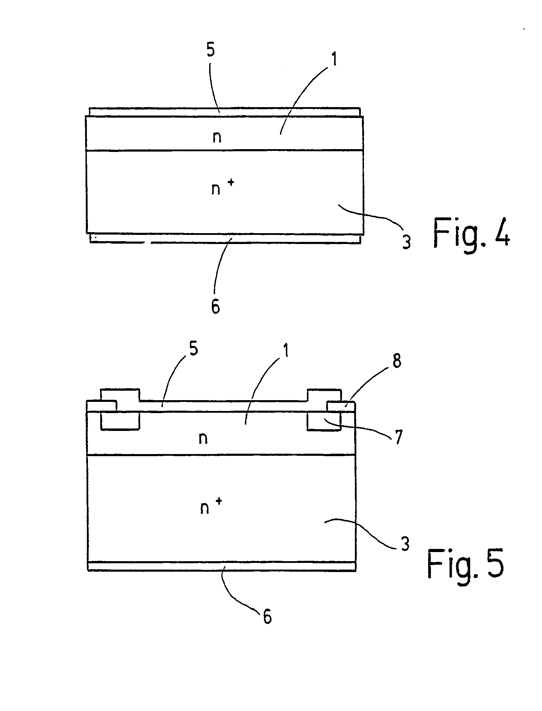

Figur 4 zeigt ein einfaches Ausführungsbeispiel einer solchen Diode. Über einer hochdotierten Zone 3 befindet eine schwächer dotierte Zone 1. Auf beiden Zonen ist jeweils eine dünne Metallschicht, zum Beispiel aus Aluminium aufgebracht. Die Metallschicht an der Unterseite des Substrats bildet eine erste Elektrode 6, die mit der darüber liegenden Zone 3 des Halbleitersubstrats in ohmschem Kontakt steht. Die Metallschicht auf der Oberseite des Halbleiters stellt eine zweite Elektrode 5 dar, die mit der Zone 1 einen Metall-Halbleiterkontakt mit Diodencharakteristik bildet. Die erste Elektrode 6 stellt die Kathode, die zweite Elektrode 5 die Anode der Diode dar.

Wird ein solches Bauelement in Sperrichtung betrieben, so tritt bei einer gewissen Grenzspannung analog zu einem einseitig abrupten pn-Übergang ein starkes Ansteigen des Sperrstroms infolge Lawinenmutliplikation auf. Allerdings sind die Grenzspannungen, bei denen ein solches Ansteigen des Stroms auftritt, meist deutlich kleiner, als man entsprechend der gewählten Dotierung der Zone 1 erwarten würde. Die Abweichung liegt typischerweise bei einem Faktor 3. Der Grund dafür ist, daß an den Kanten der Elektroden 5,6 eine Feldstärke-Überhöhung auftritt. Deshalb beginnt die Lawinenmultiplikation am Rand des Bauelements. Die Folge davon ist, daß Dioden mit dem in Figur 4 gezeigten Aufbau schon unterhalb der Durchbruchsspannung hohe Sperrströme zeigen. Beim Lawinendurchbruch treten hohe Verlustleistungen am Diodenrand auf, da sich der gesamte Durchbruchstrom auf dieses Gebiet konzentriert. Deshalb sind Dioden mit dem in Figur gezeigten einfachen Aufbau als Elemente zur Spannungsbegrenzung nicht geeignet.

Eine bekannte Lösung dieses Problems ist der in Figur 5 gezeigte Aufbau. Dieser ist zum Beispiel aus B.J. Baliga, Power Semiconductor Devices, PWS Publishing Company, Boston, USA, 1995 bekannt. Hier ist in die n-dotierte Zone 1 zusätzlich eine ringförmig umlaufende p-dotierte Schicht 7 eingebracht. Die Anode 5 ist nun mit Hilfe der in der Planartechnik üblichen Schritte so ausgebildet, daß sie einerseits mit der n-dotierten zweiten Zone 1 und der p-dotierten Schicht 7 kontaktiert ist, und daß andererseits der äußere Rand der Anode 5 auf einer Oxidschicht 8 an der Oberfläche des Halbleitersubstrats zu liegen kommt. Die umlaufende p-dotierte Schicht 7 wird als Guard-Ring bezeichnet. Auf diese Weise wird eine Verringerung der Randfeldstärke erreicht. Der Lawinendurchbruch findet nun nicht mehr bevorzugt am Rand statt, sondern ist gleichmäßig über die Oberfläche der zweiten Zone 1 innerhalb des Guard-Rings 7 verteilt. Da keine lokalen Durchbrüche am Rand bei Spannungen unterhalb der gewünschten Durchbruchs-Grenzspannung auftreten, kann eine Schottky-Diode mit Guard-Ring zur Spannungsbegrenzung verwendet werden.

Die Herstellung einer solchen Diode ist allerdings mit erhöhtem Aufwand verbunden. So ist zum einen die Herstellung einer flachen, schwach dotierten Zone wie der Zone 1 über einer höher dotierten wie der Zone 3 aufwendig, da im allgemeinen hierfür ein Epitaxieverfahren angewendet werden muß. Anschließend muß der Guard-Ring 7 strukturiert und eingebracht werden, und die Oxidschicht 8 muß strukturiert werden, um schließlich die Anode 5 in der gewünschten Form darauf abscheiden zu können.

Das Dokument WO-A-9 912 188 offenbart eine Diode mit einem zwischen zwei metallischen Elektroden angeordneten Halbleitersubstrat, das in einer ersten Zone stark dotiert ist, um einen ohmschen Übergang zu der ersten Elektrode zu bilden, und in einer zweiten Zone mit gleichem Leitfähigkeitstyp schwach dotiert ist, um einen gleichrichtenden Übergang zu der zweiten Elektrode zu bilden, wobei beide Zonen durch eine dritte Zone des Halbleitersubstrats getrennt sind, die mit gleichem Leitfähigkeitstyp schwächer als die zweite Zone dotiert ist.

Die zweite Zone ist zwischen der zweiten Elektrode, der dritten Zone, einer vierten Zone (Guard-Ring) mit entgegengesetztem Leitfähigkeitstyp und einer Isolatorschicht vollständig eingeschlossen.

Es offenbart auch ein Verfahren zum Herstellen einer Diode, wobei an einer Oberfläche einer dritten Zone eines Halbleitersubstrats, das eine stark dotierte erste Zone und die dritte Zone mit schwacher Dotierung und gleichem Leitfähigkeitstyp umfasst, eine zweite Zone mit gleichem Leitfähigkeitstyp und stärkerer Dotierung als der der dritten Zone erzeugt und auf der Oberflache eine metallische Elektrode abgeschieden wird. Die metallische Elektrode schließt die zweite Zone zwischen sich, einer vierten Zone (Guard-Ring) mit entgegengesetztem Leitfähigkeitstyp, einer Isolatorschicht und der dritten Zone vollständig ein.

### Vorteile der Erfindung

Durch die vorliegende Erfindung wird eine Diode der genannten Art geschaffen, die einfach und preiswert herzustellen ist. Diese Vorteile werden dadurch erreicht, daß bei der erfindungsgemäßen Diode die zweite Zone zwischen einer Elektrode und der dritten Zone vollständig eingeschlassen ist.

Durch geeignete Wahl der Abmessungen und Dotierungskonzentrationen der einzelnen Zonen läßt sich sicherstellen, daß die Durchbruchsspannung am Übergang von der zweiten Elektrode zur dritten Zone größer ist als zur stärker dotierten zweiten Zone. Infolgedessen ist bei Erreichen der Durchbruchspannung dieser zweiten Zone die Randfeldstärke an einem die dritte Zone berührenden Rand der zweiten Elektrode kleiner als in ihrem die zweite Zone berührenden Bereich, so daß ein Lawinendurchbruch nur in der zweiten Zone stattfindet.

Der bekannte Guard-Ring und die zu seiner Herstellung erforderlichen Prozeßschritte können deshalb entfallen. Da die Diode nur Zonen vom gleichen Leitfähigkeitstyp benötigt, kommt man mit einem einzigen Dotiermittel aus.

Vorzugsweise sind die Abmessungen und die Dotierungen der Zonen so gewählt, daß die (berechnete) Durchbruchsspannung in einem Kontaktbereich zwischen der zweiten Elektrode und der dritten Zone mindestens dreimal so groß ist wie zwischen der zweiten Elektrode und der zweiten Zone.

Gemäß einem ersten Ausführungsbeispiel ist die zweite Zone über die Oberfläche der dritten Zone erhaben, und die zweite Elektrode überdeckt hutförmig die zweite Zone und weist eine die zweite Zone berührende umlaufende Krempe auf. Eine solche Diode kann zum Beispiel in einem Herstellungsverfahren erzeugt werden, bei dem zunächst die zweite Zone auf der gesamten Oberfläche der dritten Zone des Halbleitersubstrats erzeugt und anschließend lokal abgetragen wird, um die Oberfläche der dritten Zone lokal wieder freizulegen.

Dieses lokale Abtragen kann ein Ansägen mit einer Kreissäge oder auch ein Maskier- und Ätzverfahren umfassen.

Einer zweiten Ausgestaltung zufolge kann die Oberfläche der Diode auch planar und die zweite Zone inselförmig in die dritte Zone eingebettet sein, und die zweite Elektrode ist eben und berührt die dritte Zone in einem Randbereich. Eine solche Diode kann zum Beispiel durch inselweises Aufbringen eines Dotiermittels auf die Oberfläche des mit der Konzentration der dritten Zone dotierten Halbleitersubstrats und Eindiffundieren des Dotiermittels erzeugt werden.

Um den Kontakt zwischen den Elektroden und dem Halbleitersubstrat zu verbessern, ist vorzugsweise wenigstens eine der Elektroden auf einer oxidfreien Oberfläche des Halbleitersubstrats angebracht. Um das in natürlicher Weise auf einem Halbleiterkristall vorhandene Oxid zu beseitigen, kommen eine Behandlung der Oberfläche durch Sputtern, durch Erhitzen im Ultrahochvakuum oder durch geeignetes Ätzen in Frage. Eine Sputterbehandlung, zum Beispiel mit Argon-Ionen, ist insbesondere dann einfach und zweckmäßig, wenn anschließend die Elektroden ihrerseits auch durch Sputtern von Metall auf das Halbleitersubstrat erzeugt werden sollen.

Weitere Merkmale und Vorteile der Erfindung ergeben sich aus der nachfolgenden Beschreibung von Ausführungsbeispielen mit Bezug auf die Figuren.

Es zeigen:
- Figuren 1,2 und 3: jeweils Strukturen von erfindungsgemäßen Halbleiterdioden im Querschnitt; und
- Figuren 4 und 5,: auf die bereits eingegangen worden ist analoge Querschnitte von herkömmlichen Schottky-Dioden.

### Beschreibung der Ausführungsbeispiele

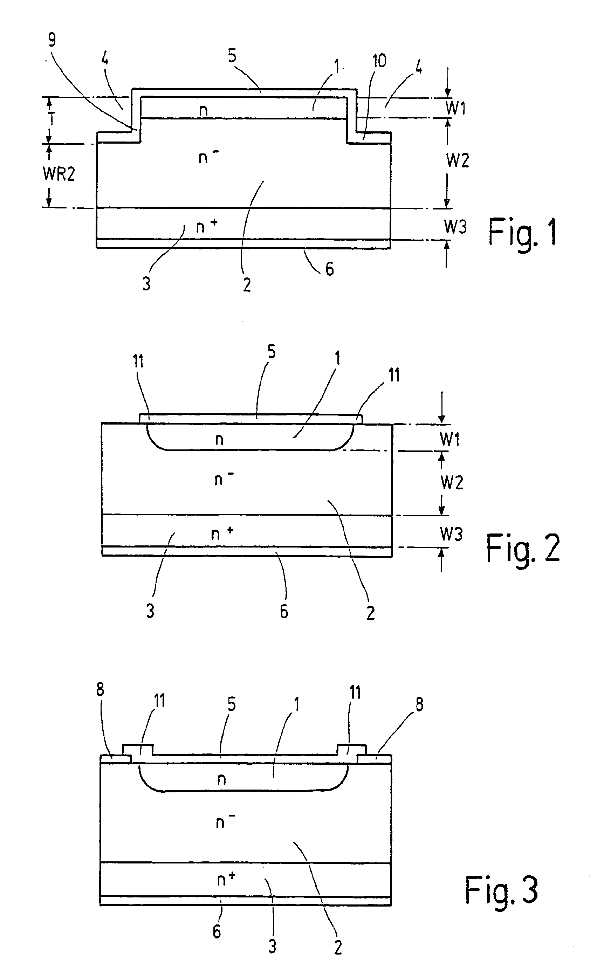

In Figur 1 ist eine erfindungsgemäße Diode schematisch im Querschnitt dargestellt. Über einer stark n-dotierten (n⁺) sogenannten ersten Halbleiterzone 3 der Weite W3 befindet sich eine schwach dotierte (n⁻) sogenannte dritte Zone 2 mit der Weite W2. Dabei ist die Weite W3 vorzugsweise kleiner als W2.

Dies ist unter Fertigungsgesichtspunkten vorteilhaft, weil es die Erzeugung der ersten Zone durch Eindiffundieren von Dotieratomen von den Oberflächen her in ein n⁻-dotiertes Substrat ermöglicht, wohingegen die Erzeugung einer schwach dotierten dünnen Schicht auf einer stärker dotierten Unterlage die Anwendung von aufwendigen Epitaxialverfahren erfordern würde.

Über der Zone 2 befindet sich eine mittelstark n-dotierte (n) sogenannte zweite Zone 1 mit der Weite W1. Diese stellt zusammen mit der dünnen Metallschicht der Anode 5 den eigentlichen Schottky-Kontakt der dargestellten Diode dar. Die Zone 1 ist in ihrer Weite und Dotierung so ausgelegt, daß eine gewünschte Sperrspannung UZ erreicht wird.

An allen Rändern des Substrats ist eine Vertiefung 4 mit der Tiefe T eingeschnitten. Diese Vertiefung quert die zweite Zone 1 und reicht jeweils bis zur schwach n-dotierten dritten Zone 2. Die Anode 5 erstreckt sich in Form eines Hutes über die gesamte Oberfläche der Zone 1 und ihre vertikalen Seitenflanken 9 im Bereich der Vertiefungen 4. Die in den Vertiefungen 4 freigelegte Oberfläche der dritten Zone 2 ist durch die Krempe 10 des Hutes überdeckt.

Eine Metallisierungsschicht an der Unterseite der zweiten Zone 3 bildet eine Kathode 6 der Diode.

Die im Bereich der Vertiefungen 4 reduzierte Weite WR2 und die Dotierung der schwach n-dotierten dritten Zone 2 sind so gewählt, daß sich für den direkten Übergang zwischen der Anode 5 und der dritten Zone 2 eine Durchbruchsspannung UZR ergibt, die mindestens dreimal so groß ist wie die Durchbruchsspannung UZ von der Anode 5 zur zweiten Zone 1. Aus diesem Grund ist, wie bereits erläutert, die Feldstärke im Randbereich, das heißt an der Krempe 10 und im Bereich der Seitenflanken 9, kleiner als in der Mitte der Anode, und der Lawinendurchbruch bleibt auf die zweite Zone 1 beschränkt.

Da außerdem anders als bei einer pn-Diode der wesentliche Anteil des Sperrstroms einer Schottky-Diode durch die Barrierenhöhe (thermionic current) bestimmt ist und die Barrierenhöhe außerdem von der Sperrspannung abhängt (Verringerung der Barriere infolge von Spiegelladungen) ist der Sperrstrom am Rand der Anode 5 am Übergang zur dritten Zone 2 sogar kleiner als im mittleren Bereich an der zweiten Zone 1.

Die in der Figur gezeigte Diode ist in folgender Weise herstellbar. Ausgehend von einem homogen n⁻-dotierten Halbleitersubstrat werden in die oberflächennahen Schichten des Substrats Dotieratome eingebracht. Diese Einbringung kann zum Beispiel durch Belegung der Oberflächen mit den Dotieratomen und anschließendes Eindiffundieren, wodurch eine Konzentrationsverteilung mit Gaußprofil erhalten wird, oder auch durch Ionenimplantation erfolgen. Auf diese Weise wird ein Halbleitersubstrat mit zwei aufdotierten Oberflächenzonen, die den späteren Zonen 1 und 3 der fertigen Diode entsprechen, und einer Mittelzone mit unveränderter Dotierungskonzentration entsprechend der dritten Zone 2 erhalten.

In einem darauf folgenden Schritt wird die schwächer dotierte der beiden Oberflächenzonen lokal abgetragen, bis die dritte Zone, deren Dotierungskonzentration unverändert geblieben ist, freiliegt. Dieses lokale Abtragen kann zum Beispiel mit Hilfe einer Kreissäge durchgeführt werden, mit der eine Vielzahl von Rillen in die Oberfläche des Substrats geschnitten werden, zwischen denen inselförmig erhabene Bereiche mit höherer Dotierung stehenbleiben.

Um die Eigenschaften des auf dieser Oberfläche aufzubringenden Schottky-Kontaktes zu verbessern, kann sich an das Sägen eine Anätzung der Halbleiteroberfläche anschließen. Dadurch wird die durch das Einsägen in ihrer Kristallstruktur gestörte Oberfläche abgetragen, und darunterliegende, unversehrt gebliebene Bereiche des Kristalls werden freigelegt.

Das Erzeugen der Vertiefungen kann auch mit anderen Verfahren wie etwa naßchemischem Ätzen oder Gasphasenätzen unter Verwendung einer entsprechenden Maskierungstechnik bewerkstelligt werden.

Vor dem Aufbringen der Elektroden 5 und 6 kann zusätzlich eine geeignete Oberflächenbehandlung des Substrats, zum Beispiel Ätzen in Flußsäure (HF) oder Ausheizen im Ultrahochvakuum durchgeführt werden, um das natürlicherweise auf der Substratoberfläche immer vorhandene Oxid zu beseitigen und so bessere Oberflächeneigenschaften für den Schottky-Kontakt zu schaffen.

Anschließend wird das Substrat auf beiden Oberflächen mit einer Metallschicht versehen. Hierfür wird vorzugsweise ein Sputterverfahren eingesetzt, da dies vor der Metallabscheidung ein Absputtern der natürlichen Oxidschicht in situ, zum Beispiel mit Argonionen, erlaubt. Nach dem Abscheiden der Metallschichten erfolgt das übliche Zerlegen des Substrats in einzelne Bauelemente. Hierzu wird wie zum lokalen Abtragen vorzugsweise eine Kreissäge eingesetzt, mit der das Substrat jeweils in der Mitte der zuvor eingesägten Vertiefungen auseinandergeschnitten wird (Dicing). Das Sägeblatt zum Zerlegen des Substrats ist deutlich schmaler als das Sägeblatt, das zum Einsägen der Vertiefungen 4 verwendet wird. Nach dem Zerlegen des Substrats erhält man die in Figur 1 im Querschnitt dargestellte Struktur.

Als konkretes Zahlenbeispiel soll auf die Herstellung einer Schottky-Diode aus Silicium mit einer Begrenzungsspannung von 48 Volt eingegangen werden. In ein Substrat mit einer homogenen Dotierung von 1,8 x 10¹⁵/cm³ und einer Waferdicke W1 + W2 + W3 von 120 *µ*m werden die Dotierstoffe in die Zone 1 (Vorderseite) und 3 (Rückseite) mittels Belegung und Diffusion eingebracht. Es werden so gaußförmige Dotierungsprofile in den Zonen 1 und 3 erhalten. Für die n-dotierte zweite Zone 1 wird eine Oberflächenkonzentration von 1,075 x 10¹⁶/cm³, für die n⁺-dotierte erste Zone 3 eine Oberflächenkonzentration von 1 x 10²⁰/cm³ gewählt. Die Diffusionslänge beträgt in beiden Fällen 17 µm. Die Tiefe T der die zweite Zone 1 ringsum umgebenden Vertiefung 4 beträgt 35 *µ*m. Die Breite der Vertiefung 4 vor dem Vereinzeln der einzelnen Bauelemente beträgt ca. 100 *µ*m. Die Elektroden 5 und 6 bestehen jeweils aus einem lötbaren Schichtsystem mit Schichten aus Cr, NiV und Ag mit Schichtdicken von etwa 80,150 beziehungsweise 80 Nanometer. Beim Trennen der Dioden voneinander wird ein schmales Sägeblatt von zum Beispiel 40 µm Breite eingesetzt, so daß die Vertiefung 4 und die darin freigelegte, mit Metall bedeckte Oberfläche der dritten Zone 2 erhalten bleibt.

Eine Oberfläche, an der inselförmige zweite Zonen 1 durch dazwischenliegende Bereiche der dritten Zone 2 getrennt sind, kann auch durch eine planare Strukturierung erzielt werden. Ein Ausführungsbeispiel ist in Figur 2 gezeigt. Hier haben die n-dotierte zweite Zone 1 und die n⁻-dotierte dritte Zone 2 eine gemeinsame plane Oberfläche, auf der die Anode 5 die gesamte zweite Zone 1 und, in ihren Randbereichen 11, einen Teil der Oberfläche der dritten Zone 2 abdeckt. Die Wirkungsweise dieser Ausgestaltung ist die gleiche wie im Fall der Figur 1. Die Dotierungsprofile für die Zonen 1 und 3 können wie oben in Verbindung mit Figur 1 beschrieben gewählt sein. Dabei kann die Weite der schwach dotierten Zone sogar noch etwas kleiner gewählt werden (für eine Durchbruchsspannung UZ von 48 Volt muß W1 + W2 größer als 8 µm sein.) Wichtig ist, daß die Anode 5 in alle Richtungen über die seitliche Ausdiffusion der zweiten Zone 1 hinausragt, so daß die Randbereiche 11 einen die zweite Zone 1 vollständig umlaufenden Ring an der Oberfläche der dritten Zone 2 bilden.

Ein drittes Beispiel einer erfindungsgemäßen Schottky-Diode ist in Figur 3 dargestellt. Sie entspricht weitgehend der Ausgestaltung aus Figur 2; zusätzlich ist noch eine Isolatorschicht 8, zum Beispiel aus SiO₂ am Rand des Halbleitersubstrats vorhanden, auf die sich der Rand der Anode 5 erstreckt. Deshalb kommt bei dieser Ausgestaltung zu der Feldstärkereduzierung durch die hochohmige dritte Zone 2 am Rand zusätzlich noch der Effekt einer Feldplatte hinzu.

Die hier beschriebenen Dioden und Herstellungsverfahren, insbesondere diejenigen nach Figur 1, eignen sich für die Herstellung von Dioden mit Silicium, insbesondere aber auch mit Siliciumcarbid als Halbleitermaterial. Derartige SiC-Dioden sind für den Einsatz bei hohen Temperaturen und hohen Spannungen (> 50 Volt) von besonderem Interesse. Bei derartigen Spannungen sind herkömmliche Dioden aus Silicium aufgrund ihrer hohen Sperrströme und Sperrverluste nur schwer einsetzbar. Siliciumcarbid ist hier aufgrund seiner niedrigen Diffusionskoeffizienten von Dotieratomen als Halbleitermaterial besser geeignet. Diese niedrigen Diffusionskoeffizienten erschweren aber gleichzeitig die Verarbeitung dieses Materials, denn sie erschweren oder verhindern ein Dotieren durch Aufbringen eines Dotiermittels auf die Oberfläche des Halbleitersubstrats und Eindiffundieren desselben. Zur Herstellung einer Schottky-Diode aus Siliciumcarbid mit der in Figur 1 gezeigten Struktur werden deshalb die Zonen 2 und 1 mittels Epitaxie auf ein SiC-Substrat aufgebracht. Die Erzeugung der Vertiefungen 4 kann dabei zum Beispiel mittels Trockenätzen auf Basis von fluorhaltigen Gasen erfolgen.

## Patentansprüche

1. Diode mit einem zwischen zwei metallischen Elektroden (5, 6) angeordneten Halbleitersubstrat, das in einer ersten Zone (3) stark dotiert ist, um einen ohmschen Übergang zu der ersten Elektrode (6) zu bilden, und in einer zweiten Zone (1) mit gleichem Leitfähigkeitstyp schwach dotiert ist, um einen gleichrichtenden Übergang zu der zweiten Elektrode (5) zu bilden, wobei beide Zonen (1, 3) durch eine dritte Zone (2) des Halbleitersubstrats getrennt sind, die mit gleichem Leitfähigkeitstyp schwächer als die zweite Zone (1) dotiert ist, **dadurch gekennzeichnet, dass** die zweite Zone (1) zwischen der zweiten Elektrode (5) und der dritten Zone (2) vollständig eingeschlossen ist.

2. Diode nach Anspruch 1, **dadurch gekennzeichnet, daß** die Durchbruchsspannung zwischen der zweiten Elektrode (5) und der dritten Zone (2) wenigstens dreimal so hoch ist wie zwischen der zweiten Elektrode (5) und der zweiten Zone (1).

3. Diode nach Anspruch 1 oder 2, **dadurch gekennzeichnet, daß** die zweite Zone (1) über die Oberfläche der dritten Zone (2) erhaben ist, daß die zweite Elektrode (5) hutförmig die zweite Zone (1) überdeckt und eine die dritte Zone (2) berührende umlaufende Krempe (10) aufweist.

4. Diode nach Anspruch 1 oder 2, **dadurch gekennzeichnet, daß** die zweite Zone (1) planar und inselförmig an der Oberfläche der dritten Zone (2) ausgebildet ist, und daß die zweite Elektrode (5) eben ist und in einem Randbereich (11) die dritte Zone (2) berührt.

5. Diode nach einem der vorhergehenden Ansprüche, **dadurch gekennzeichnet, daß** eine Isolatorschicht (8) auf der Oberfläche der dritten Zone (2) die zweite Zone (1) umgebend ausgebildet ist, und daß die zweite Elektrode (5) mit ihrem Rand die Isolatorschicht (8) berührt.

6. Diode nach einem der vorhergehenden Ansprüche, **dadurch gekennzeichnet, daß** wenigstens eine der Elektroden (5,6) auf einer oxidfreien Oberfläche des Halbleitersubstrats angebracht ist.

7. Diode nach einem der vorhergehenden Ansprüche, **dadurch gekennzeichnet, daß** das Halbleitersubstrat Si oder SiC ist.

8. Verfahren zum Herstellen einer Diode, insbesondere nach einem der vorhergehenden Ansprüche, wobei an einer Oberfläche einer dritten Zone (2) eines Halbleitersubstrats, das eine stark dotierte erste Zone (3) und die dritte Zone (2) mit schwacher Dotierung und gleichem Leitfähigkeitstyp umfasst, eine zweite Zone (1) mit gleichem Leitfähigkeitstyp und stärkerer Dotierung als der der dritten Zone (2) erzeugt und auf der Oberfläche eine metallische Elektrode (5) abgeschieden wird, **dadurch gekennzeichnet, dass** die metallische Elektrode die zweite Zone (1) zwischen sich und der dritten Zone (2) vollständig einschließt.

9. Verfahren nach Anspruch 8, **dadurch gekennzeichnet, daß** die zweite Zone (1) auf der gesamten Oberfläche der dritten Zone (2) erzeugt und anschließend lokal abgetragen wird, um die dritte Zone (2) lokal wieder freizulegen.

10. Verfahren nach Anspruch 8, **dadurch gekennzeichnet, daß** die zweite Zone (1) durch epitaxiales Schichtwachstum erzeugt wird.

11. Verfahren nach Anspruch 9 oder 10, **dadurch gekennzeichnet, daß** das lokale Abtragen ein Ansägen mit einer Kreissäge umfaßt.

12. Verfahren nach Anspruch 9 oder 10, **dadurch gekennzeichnet, daß** das lokale Abtragen ein Maskieren und Ätzen umfaßt.

13. Verfahren nach einem der Ansprüche 8 bis 12, **dadurch gekennzeichnet, daß** die Elektroden (5,6) durch Sputtern abgeschieden werden.

14. Verfahren nach einem der Ansprüche 8 bis 13, **dadurch gekennzeichnet, daß** die Oberfläche des Halbleitersubstrats vor dem Abscheiden der Elektroden (5,6) durch Sputtern oxidfrei gemacht wird.

15. Verfahren nach einem der Ansprüche 8 bis 14, **dadurch gekennzeichnet, daß** das Halbleitersubstrat vor dem Abscheiden der Elektroden (5,6) im Ultrahochvakuum erhitzt wird, um seine Oberfläche von Oxid zu befreien.

16. Verfahren nach einem der Ansprüche 8 bis 15, **dadurch gekennzeichnet, daß** das Halbleitersubstrat vor dem Abscheiden der Elektroden (5,6) geätzt wird.

## Claims

1. Diode comprising a semiconductor substrate arranged between two metallic electrodes (5, 6), which semiconductor substrate is heavily doped in a first zone (3) in order to form an ohmic junction with the first electrode (6), and is weakly doped in a second zone (1) with the same conductivity type in order to form a rectifying junction with the second electrode (5), the two zones (1, 3) being separated by a third zone (2) of the semiconductor substrate, which third zone is doped with the same conductivity type more weakly than the second zone (1), **characterized in that** the second zone (1) is completely enclosed between the second electrode (5) and the third zone (2).

2. Diode according to Claim 1, **characterized in that** the breakdown voltage between the second electrode (5) and the third zone (2) is at least three times as high as between the second electrode (5) and the second zone (1).

3. Diode according to Claim 1 or 2, **characterized in that** the second zone (1) is elevated over the surface of the third zone (2), **in that** the second electrode (5) covers the second zone (1) in hat-shaped fashion and has a circumferential brim (10) that touches the third zone (2).

4. Diode according to Claim 1 or 2, **characterized in that** the second zone (1) is formed in planar and insular fashion at the surface of the third zone (2) and **in that** the second electrode (5) is plane and touches the third zone (2) in an edge region (11).

5. Diode according to one of the preceding claims, **characterized in that** an insulator layer (8) is formed on the surface of the third zone (2) in a manner surrounding the second zone (1), and **in that** the second electrode (5) touches the insulator layer (8) by its edge.

6. Diode according to one of the preceding claims, **characterized in that** at least one of the electrodes (5, 6) is applied on an oxide-free surface of the semiconductor substrate.

7. Diode according to one of the preceding claims, **characterized in that** the semiconductor substrate is Si or SiC.

8. Method for the production of a diode, in particular according to one of the preceding claims, in which case, at a surface of a third zone (2) of a semiconductor substrate comprising a heavily doped first zone (3) and the third zone (2) having weak doping and the same conductivity type, a second zone (I) having the same conductivity type and heavier doping than that of the third zone (2) is produced and a metallic electrode (5) is deposited on the surface, **characterized in that** the metallic electrode completely encloses the second zone (1) between itself and the third zone (2).

9. Method according to Claim 8, **characterized in that** the second zone (1) is produced on the entire surface of the third zone (2) and is subsequently removed locally in order to locally uncover the third zone (2) again.

10. Method according to Claim 8, **characterized in that** the second zone (1) is produced by epitaxial layer growth.

11. Method according to Claim 9 or 10, **characterized in that** the local removal comprises sawing with a circular saw.

12. Method according to Claim 9 or 10, **characterized in that** the local removal comprises masking and etching.

13. Method according to one of Claims 8 to 12, **characterized in that** the electrodes (5, 6) are deposited by sputtering.

14. Method according to one of Claims 8 to 13, **characterized in that** the surface of the semiconductor substrate is made oxide-free prior to the deposition of the electrodes (5, 6) by sputtering.

15. Method according to one of Claims 8 to 14, **characterized in that** the semiconductor substrate is heated in ultrahigh vacuum prior to the deposition of the electrodes (5, 6) in order to free its surface of oxide.

16. Method according to one of Claims 8 to 15, **characterized in that** the semiconductor substrate is etched prior to the deposition of the electrodes (5, 6).

## Revendications

1. Diode comportant entre deux électrodes métalliques (5, 6) un substrat semi-conducteur fortement dopé dans une première zone (3) pour former une transition ohmique vers la première électrode (6), et faiblement dopé dans une deuxième zone (1) avec le même type de conductibilité, pour former une transition de redressement vers la seconde électrode (5), les deux zones (1, 3) étant séparées par une troisième zone (2) du substrat semi-conducteur qui est plus faiblement dopée que la deuxième zone (1) avec le même type de conductibilité,
**caractérisé en ce que**
la deuxième zone (1) est complètement incluse entre la seconde électrode (5) et la troisième zone (2).

2. Diode selon la revendication 1,
**caractérisée en ce que**
la tension de claquage entre la seconde électrode (5) et la troisième zone (2) est au moins trois fois aussi élevée qu'entre la seconde électrode (5) et la deuxième zone (1).

3. Diode selon la revendication 1 ou 2,
**caractérisée en ce que**
la deuxième zone (1) est au-dessus de la troisième zone (2), la seconde électrode (5) recouvre la deuxième zone (1) en forme de chapeau et présente une bordure périphérique (10) en contact avec la troisième zone (2).

4. Diode selon la revendication 1 ou 2,
**caractérisée en ce que**
la deuxième zone (1) est planaire et en forme d'île sur la surface de la troisième zone (2), et la seconde électrode (5) est plate et en contact avec la troisième zone (2) dans une zone de bord (11).

5. Diode selon l'une quelconque des revendications précédentes,
**caractérisée en ce qu'**
une couche d'isolateur (8) sur la surface de la troisième zone (2) entoure la deuxième zone (1), et la seconde électrode (5) fait contact par son bord avec la couche d'isolateur (8).

6. Diode selon l'une quelconque des revendications précédentes,
**caractérisée en ce qu'**
au moins une des électrodes (5, 6) est placée sur une surface exempte d'oxyde du substrat semi-conducteur.

7. Diode selon l'une quelconque des revendications précédentes,
**caractérisée en ce que**
le substrat semi-conducteur est en Si ou en SiC.

8. Procédé de fabrication d'une diode, en particulier, selon l'une quelconque des revendications précédentes,
selon lequel on produit sur une surface d'une troisième zone (2) d'un substrat semi-conducteur, qui présente une première zone (3) fortement dopée et la troisième zone (2) avec un dopage faible et le même type de conductibilité, une deuxième zone (1) avec le même type de conductibilité et un dopage plus fort que celui de la troisième zone (2), avec une électrode métallique (5) déposée sur la surface,
**caractérisé en ce que**
l'électrode métallique inclut complètement la deuxième zone (1) entre elle et la troisième zone (2).

9. Procédé selon la revendication 8,
**caractérisé en ce que**
la deuxième zone (1) est produite sur la surface totale de la troisième zone (2) et est ensuite éliminée localement, pour dégager de nouveau la troisième zone (2) localement.

10. Procédé selon la revendication 8,
**caractérisé en ce que**
la deuxième zone (1) est produite par croissance épitaxiale de couche.

11. Procédé selon la revendication 9 ou 10,
**caractérisé en ce que**
l'élimination locale comprend un sciage à la scie circulaire.

12. Procédé selon la revendication 9 ou 10,
**caractérisé en ce que**
l'élimination locale comprend le masquage et la gravure.

13. Procédé selon l'une quelconque des revendications 8 à 12,
**caractérisé en ce que**
les électrodes (5,6) sont déposées par pulvérisation.

14. Procédé selon l'une quelconque des revendications 8 à 13,
**caractérisé en ce que**
la surface du substrat semi-conducteur est rendue exempte d'oxyde par pulvérisation avant la séparation des électrodes (5,6).

15. Procédé selon l'une quelconque des revendications 8 à 14,
**caractérisé en ce que**
le substrat semi-conducteur est chauffé avant la séparation des électrodes (5,6) dans l'ultravide pour débarrasser sa surface d'oxyde.

16. Procédé selon l'une quelconque des revendications 8 à 15,
**caractérisé en ce que**
le substrat semi-conducteur est gravé avant la séparation des électrodes (5,6).
